Europäisches Patentamt

European Patent Office

Office européen des brevets

(11) Publication number: **0 315 335**
**A2**

## (12) EUROPEAN PATENT APPLICATION

(21) Application number: **88309763.6**

(51) Int. Cl.4: **G01R 11/24**

(22) Date of filing: **18.10.88**

(30) Priority: **02.11.87 GB 8725638**

(43) Date of publication of application:
**10.05.89 Bulletin 89/19**

(84) Designated Contracting States:
**AT BE CH DE ES FR GB GR IT LI LU NL SE**

(71) Applicant: **EAST MIDLANDS ELECTRICITY BOARD**
**P.O. Box 4 North P.D.O. 398 Coppice Road Arnold Nottinghamshire NG5 7HX(GB)**

(72) Inventor: **Birt, Graham William Roderick**
**16 Vernon Crescent**
**Ravenshead Nottinghamshire. NG15 9BL(GB)**

(74) Representative: **Wayte, Dennis Travers et al**
**BOULT, WADE & TENNANT 27 Furnival Street London, EC4A 1PQ(GB)**

(54) Detection apparatus.

(57) The apparatus includes a detection means (7) with piezoelectric properties and is used to detect mechanical interference with an electrical power supply arrangement (1, 2, 3, 4, 5).

FIGURE 1

EP 0 315 335 A2

## DETECTION APPARATUS

This invention relates to detection apparatus, and particularly to detection apparatus for detecting mechanical interference with an electrical power supply arrangement.

Electricity meters, as used in domestic and other premises for recording electricity usage, are vulnerable to deliberate damage done in order to stop the meter or to modify its reading so that electricity may be abstracted without payment. Such damage may be mechanical, either externally or, via the meter casing, to the internal mechanism, or it may be electrical, either by bypassing the meter or by connecting devices to the meter wiring.

In all such cases, mechanical interference with the meter or to associated wiring or other equipment, e.g. a cut-out, takes place.

According to this invention there is provided detection apparatus for detecting mechanical interference with an electrical power supply arrangement, characterised by detector means having piezoelectric properties arranged to be responsive to the application or removal of pressure on the detector means caused by mechanical interference with said arrangement and operative to provide an electrical signal when so responding, and indicator means responsive to said electrical signal provided by the detector means to indicate interference with said arrangement.

With such apparatus the detector means can be a body of piezoelectric material having electrodes at which said electrical signal is provided, or a body incorporating a layer of piezoelectric material with associated electrodes at which said electric signal is provided. Otherwise the detector means can comprise a body carrying one or more discrete piezoelectric transducers which provide said electrical signal.

The detection means can be in the form of a sleeve adapted to receive a part of the electrical power supply system, for example, a conductor, therein, whereby any attempt to interfere with that part of the system will result in production of said electrical signal.

This invention will now be described by way of example with reference to the drawing, in which:-

Figure 1 is a schematic diagram of the detection means of an apparatus according to the invention in position on an electrical power supply arrangement; and

Figures 2, 3 and 4 illustrate three different forms of indicator means for use with the detection means of Figure 1.

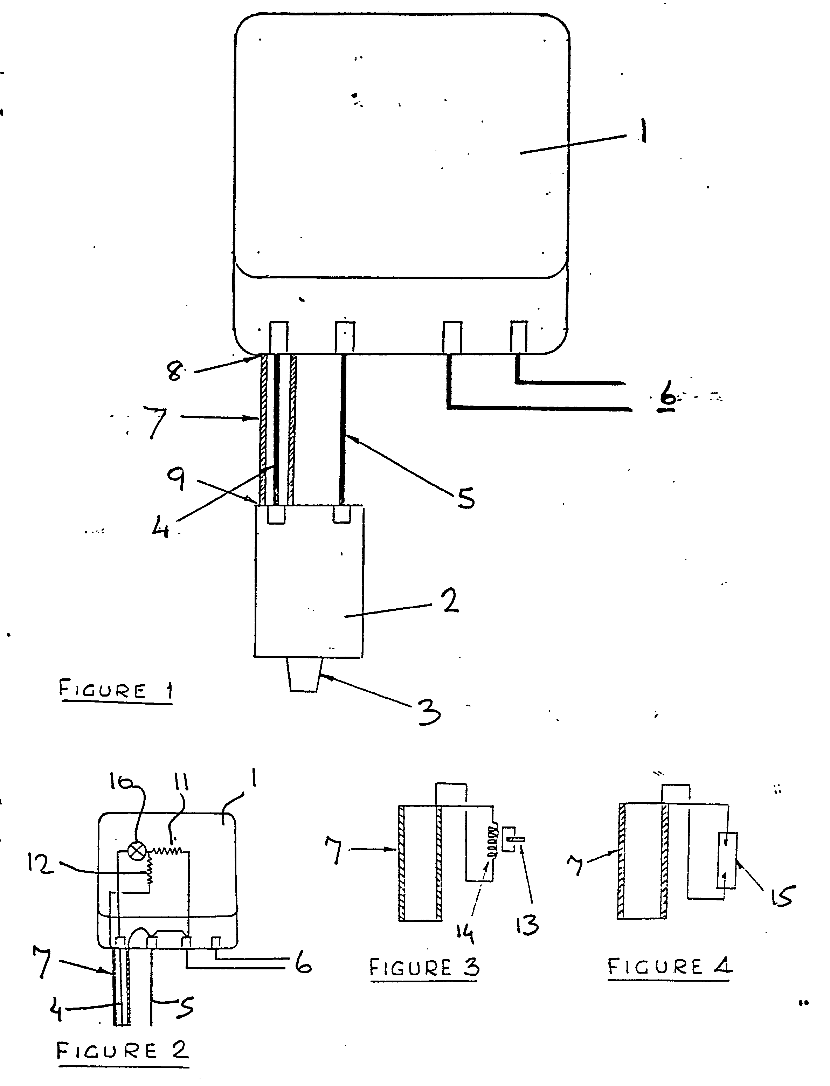

Referring now to the drawings, Figure 1 shows a domestic single phase electrical power supply arrangement metering point comprising a kWh meter 1 and a fuse and cut-out unit 2 which receives an incoming mains supply cable (not shown) at 3. From the unit 2 power is supplied to the meter 1 by way of insulated live and neutral conductors 4 and 5 which will generally be as short as is practicable. Loads requiring electrical power are connected to the meter 1 by a cable 6, any power drawn by the loads from the supply at 3 being recorded by the meter 1 for charging purposes.

In order to obtain power without payment it is necessary for the power to be obtained from the supply at 3 upstream of the meter 1, and it is known for this to be done by establishing connections to the conductors 4 and 5 in some manner, for example by the use of insulation piercing connectors. Whatever method of establishing connections is used there will be some mechanical interference with the conductors 4 and 5, and the apparatus to be described serves to detect such interference.

As shown in Figure 1, the live conductor 4 is surrounded by a detector means in the form of a sleeve 7 which extends between the meter 1 and unit 2. Thus, for contact to be made to the live conductor 4, the sleeve 7 must be interfered with. The sleeve 7 is made of a semi-flexible material having piezoelectric properties or incorporates a piezoelectric material layer, such that when pressure is applied to any point on the sleeve 7, a voltage is produced which is proportional to the rate of change of the applied pressure or to the degree of distortion of the sleeve. Electrodes (not shown) are incorporated in the sleeve 7 by which the voltage produced is supplied to indicator means as to be described below. The ends of the sleeve 7 are secured to the meter 1 and unit 2 respectively by means of an adhesive, and the sleeve 7 is in axial compression, such that any relative movement between the meter 1 and the unit 2, as well as any interference with the sleeve 7, will result in production of the signal voltage. It is not essential for the whole of the sleeve 7 to have piezoelectric properties; discrete piezoelectric transducers can be located on the sleeve, for example at the ends 8 and 9, and arranged to provide the necessary signal voltage.

Referring now to Figures 2, 3 and 4, these show three indicator means to which the signal voltage from the sleeve 7 of Figure 1 can be supplied.

In Figure 2 a small gas discharge lamp 10, typically neon, is located inside the casing of the meter 1, to be visible to the outside thereof. The lamp 10 is connected in series with a high resistance 11 between the live and neutral conductors 4 and 5, the value of resistance 11 being sufficiently high to ensure that the lamp 10 is normally not glowing. Any signal voltage from the sleeve 7 is superimposed on the supply to the lamp 10 by way of a resistor 12, and this causes the lamp 10 to strike and glow. Thereafter the lamp 10 is maintained glowing by the supply on conductors 4 and 5.

As modification of this arrangement the signal voltage from the sleeve 7 can be used to operate a latching relay, preferably solid state, energised as for the lamp 10 from the conductors 4 and 5, the relay when operated causing energisation of a light emitting diode or similar device. This arrangement has the advantage that even if after interference and thus lighting of the diode or other light emitting device, the power supply is cut off, when the supply is reinstated the indication of interference will again be given.

Figure 3 shows an indicator means comprising a length of magnetic recording tape 13 and a recording head 14 to which the electrical signal from the sleeve 7 is supplied. The head 7 can conveniently be located in the unit 2. With this arrangement any electrical signal produced by the sleeve 7 as a result of mechanical interference is recorded on the tape 13 and can thereafter be detected in known manner, for example by using a detector of the type comprising a suspension of ferromagnetic particles in a carrier liquid.

In the detector means of Figure 4 the signal voltage from the sleeve 7 is applied to a cell 15 containing a chemical which changes colour in response thereto and thus gives an indication of mechanical interference. The colour change can be at the ultra violet end of the spectrum and be detected by the use of an ultra violet lamp, being otherwise invisible.

## Claims

1. Detection apparatus for detecting mechanical interference with an electrical power supply arrangement, characterised by detector means (7) having piezoelectric properties arranged to be responsive to the application or removal of pressure on the detector means (7) caused by mechanical interference with said arrangement and operative to provide an electrical signal when so responding, and indicator means (10; 13, 14; 15) responsive to said electrical signal provided by the detector means (7) to indicate interference with said arrangement.

2. Detection apparatus as claimed in Claim 1, characterised in that the detector means (7) is a body of piezoelectric material having electrodes at which said electrical signal is provided.

3. Detection apparatus as claimed in Claim 1, characterised in that the detection means (7) comprises a body incorporating a layer of piezoelectric material with associated electrodes at which said electrical signal is provided.

4. Detection apparatus as claimed in Claim 1, characterised in that the detection means (7) comprises a body carrying one or more discrete piezoelectric transducers which provide said electrical signal.

5. Detection apparatus as claimed in any preceding claim, characterised in that the detection means (7) is, before any interference, maintained under compression.

6. Detection apparatus as claimed in any preceding claim, characterised in that the indicator means is a lamp (10) which is lit by said electrical signal.

7. Detection apparatus as claimed in any one of Claims 1 to 5, characterised in that the indicator means is a latching relay which when operated by said electrical signal causes energisation of a light emitting device.

8. Detection apparatus as claimed in any one of Claims 1 to 5, characterised in that the indicator means comprises a magnetic recording tape (13) and means (14) to record on the tape (13) indication of the occurrence of said electrical signal.

9. Detection apparatus as claimed in any one of Claims 1 to 5, characterised in that the indicator means comprises a body of liquid (15) which undergoes a colour change on application of said electrical signal thereto.

10. Detection apparatus as claimed in Claim 9, characterised in that said colour change is detectable only under particular lighting conditions.

11. Detection apparatus as claimed in any preceding claim, characterised in that the detection means (7) is in the form of a sleeve adapted to receive a part of said arrangement therein.

FIGURE 1

FIGURE 2

FIGURE 3

FIGURE 4